# EUROPEAN PATENT APPLICATION

(11) **EP 4 261 854 A1**
(43) Date of publication of application: **18.10.2023**
(21) Application number: 23167493.8
(22) Date of filing: 12.04.2023
(51) Int. Cl.: H01F 5/04, H01F 7/128

(54) **COIL FOR AN ELECTROMAGNETIC ACTUATOR, METHOD FOR MANUFACTURING SUCH A COIL, AND ELECTROMAGNETIC ACTUATOR COMPRISING SUCH A COIL**

(30) Priority: 13.04.2022 IT 202200007403
(71) Applicant: LMP srl, 80038 Napoli (IT)
(72) Inventor: DE NATALE, Gabriele Valentino, 80128 NAPOLI (IT); D'ALESSANDRO, Fedele, 80038 POMIGLIANO D'ARCO, NA (IT)
(74) Representative: Lavoix

(57) **Abstract**

Coil (100) for an electromagnetic actuator, comprising at least:
- a support (1);
- an electrical winding (10) comprising a plurality of turns wound around the support (1); characterized in that it further comprises an electronic circuit (20) which comprises a flexible printed circuit board (22) on which there are arranged one or more electronic components (24) and which is wound, at least in part, around said electrical winding (10).

The invention further relates to an electromagnetic actuator comprising such a coil.

## Description

The present invention relates to a coil for an electromagnetic actuator, to a method for manufacturing such a coil, and to an electromagnetic actuator comprising such a coil.

The coil according to the invention, which may also be referred to as a solenoid, is particularly suitable for use in an electromagnetic actuator of a linear type, and will be described below with reference to such an application without intending to limit its possible use in other types of actuators.

As is well known, linear electromagnetic actuators use for their operation the force of attraction exerted on a moving part, usually referred to as a moving plunger, by an electromagnet consisting of a solenoid and a core of ferromagnetic material.

Such electromagnetic actuators are often operationally associated with different types of electronic control circuits whose functions may be of different types depending on the applications.

Currently, these electronic circuits are typically housed in an enclosure, e.g., made of plastic, separate from the electromagnet, and are implemented by means of a rigid printed circuit board, usually of a flat surface.

In these applications, the presence of the electronic circuit is highly visible because of the plastic enclosure, which increases the overall footprint of the actuator.

Also, in the most common solutions, for actuators that have a typical rectangular parallelepiped external shape, the electronic circuit is attached to one of the larger sides of the parallelepiped, and therefore the size of the printed circuit board is limited by the same surface area as the side of the parallelepiped to which it is attached.

Finally, the electronic circuit is connected to the solenoid or coil by additional cables and connectors, which increases the complexity and cost of implementation.

Therefore, the main purpose of the present invention is to provide a solution that will at least mitigate, if not completely solve, one or more of the above-mentioned drawbacks, and in particular to make a coil that has a small footprint and is easier to implement than solutions of known types.

This main purpose, and others that will eventually result from the following description, are achieved by a coil for an electromagnetic actuator whose characteristics are defined in claim 1.

This main purpose is further achieved by an electromagnetic actuator, in particular of a linear type, characterized by comprising at least one coil as described below, and in particular as defined by the appended claims.

Finally, this main purpose is achieved by a method for manufacturing a coil according to claim 8.

Particular embodiments form the subject matter of the dependent claims, the contents of which are intended to form an integral part of this description.

Further characteristics and advantages of the invention will appear from the following detailed description, made purely by way of non-limiting example, with reference to the accompanying drawings, in which:
figure 1 schematically illustrates a possible embodiment of a coil according to the present invention;
figures 2 to 4 illustrate some components of the coil of figure 1 in various stages of assembly;
figure 5 is a flow chart schematically illustrating a method for manufacturing a coil according to the present invention.

It should be noted that in the detailed description that follows, identical or similar components, from a structural and/or functional point of view, may have the same or different reference numbers, regardless of whether they are shown in different forms of embodiments of the present invention or in different parts.

It should also be noted that in order to clearly and concisely describe the present invention, the drawings may not necessarily be to scale and some features of the description may be shown in a somewhat schematic form.

In addition, when the term "adapted" or "arranged" or "configured" or "shaped" or a similar term is used herein, referring to any component as a whole, or to any part of a component or to a combination of components, it should be understood to mean and correspondingly include the structure and/or configuration and/or shape and/or positioning.

In particular, when such terms refer to electronic hardware or software means, they are to be understood as including circuits or parts of electronic circuits, as well as software/firmware, such as algorithms, routines and programs in general, running and/or residing in any storage medium.

In addition, when the term "substantial" or "substantially" is used herein, it is to be understood as including a current variation of plus or minus 5 percent from what is indicated as the reference value or position, and when the terms "transversely" or "transversely" are used herein, they are to be understood as including a direction that is not parallel to the reference part(s)/direction(s)/axis(s) to which they refer, and perpendicularity is to be considered a specific case of transverse direction.

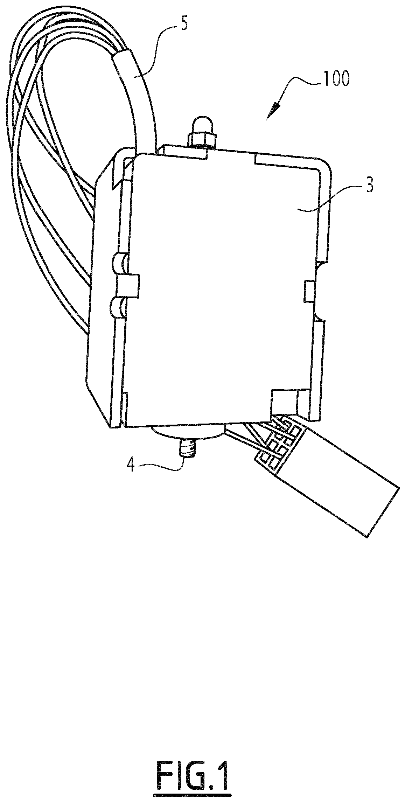

Figure 1 illustrates a coil for an electromagnetic actuator according to the invention, indicated by the overall reference number 100.

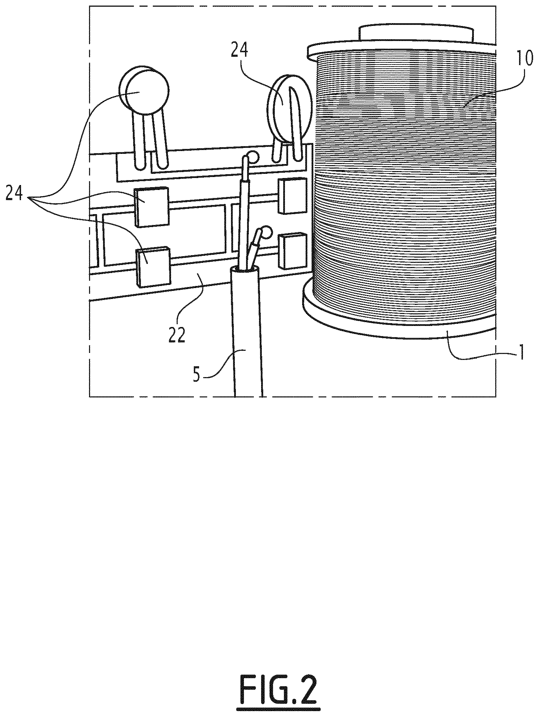

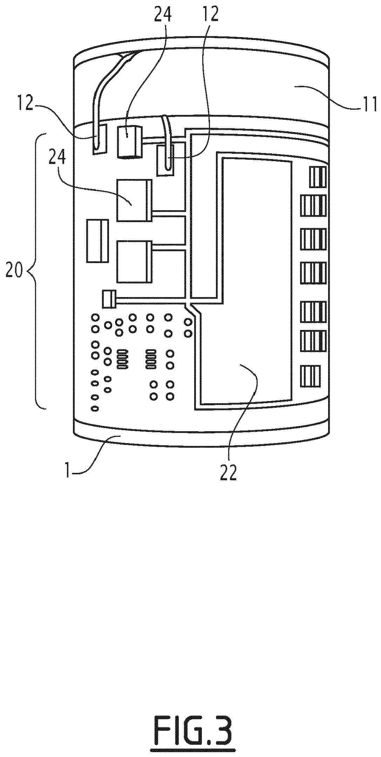

As better visible in Figures 2 and 3, the coil 100, which can also be referred to as a solenoid, comprises:
- a support or spool or shaft 1 of a shape per se known, having, for example, a central body, e.g., substantially cylindrical, and two ends, e.g., substantially circular in development, extending transversely from the ends of the central body;
- an electrical winding, indicated by the overall reference numeral 10, which comprises a plurality of turns wound around the central body of the support 1 between the two ends.

For example, such a winding can be made by using an appropriate conducting wire, such as an enameled wire.

Conveniently, the coil 100 according to the invention further comprises an electronic circuit 20 that includes a flexible printed circuit board 22 on which one or more electronic components 24 are arranged and that is wrapped, at least partially, preferably completely, around the electrical winding 10.

In one possible embodiment, the flexible printed circuit board 22 is conveniently provided with a layer of double-sided adhesive tape that facilitates attachment to the electrical winding 10.

Accordingly, the double-sided adhesive tape allows to directly attach the flexible printed circuit board 22 onto the electrical winding 10.

The electronic circuit 20 is suitable for generating one or more control signals for the electromagnetic actuator and, depending on the specific application, can be suitably configured to perform one or more functions such as but not limited to:
- the conversion of an alternating current into the direct current required to control the actuator;
- the control of the magnetomotive force required by the actuator, high for the launch phase and low for holding;
- the regulation of the current by switching techniques, such as PWM type;
- timing, actuation delays, et cetera;
- various protections, e.g., a thermal protection.

As a matter of fact, according to forms widely known or easy to make for a person skilled in the art, the electronic components 24 used may be of a variety of types and appropriately operationally associated with each other, such as MOSFETs, varistors, rectifier bridges, various protection elements, such as bimetallic pairs for thermal protection, et cetera.

Before winding the electronic circuit 20, according to a possible embodiment, a tape 11 can be placed on the outer surface of the electrical winding 10 as shown in Figure 3.

Thus, according to this embodiment, the tape 11 is placed around and on the outer surface of the winding 10, and then the flexible printed circuit board 22 is wound around the electrical winding 10 and attached, via its double-sided adhesive tape, onto the tape 11.

Conveniently, according to a possible embodiment of the coil 100 according to the invention, double-sided adhesive and as visible in figure 3, the ends 12 of the electrical winding 10 are soldered directly onto the flexible printed circuit board 22, thus without the use of additional cables and/or connectors typical of known solutions.

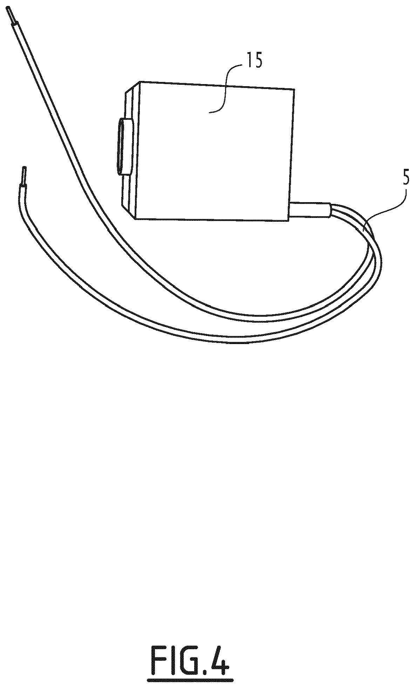

According to a possible embodiment, the coil 100 also includes at least one layer of resin, indicated in Figure 4 by the reference number 15, that is cast around the electronic circuit 20 assembly (wrapped around the electrical winding 10)-electrical winding 10 itself.

In particular, the resin layer 15 encapsulates, at least partially, preferably completely, the electrical winding 10 and the electronic circuit 20 by mechanically solidarizing them together.

In an alternative embodiment, instead of the resin layer, the coil 100 includes at least one layer of plastic material, such as a thermoplastic or thermosetting material. Such a layer of plastic material replaces the resin and is co-molded with at least part of, preferably all, the assembly formed by the electrical winding 10 and the electronic circuit 20, mechanically solidarizing them together in a manner similar to that done by the resin layer 15.

As illustrated in Figure 1, the coil 100 also includes a ferromagnetic casing or shell 3, which forms in fact the outer housing of the coil itself and is arranged around the electrical winding 10 with the electronic circuit 20 interposed between them.

For example, the outer casing 3 has a shape of a substantially parallelepiped envelope inside of which is placed the pre-assembled assembly formed by the support 1, the electrical winding 10, and the electronic circuit 20.

Such outer casing 3 can be formed by an appropriate number of parts assembled together; for example, in the embodiment of Figure 1, the casing 3 is formed by two C-shaped parts connected together.

As can be seen in Figure 3, the moving plunger 4 of the coil 100 emerges from one end of the casing 3, while, for example, the cables 5 for connecting the coil 100 to at least one electrical power source emerge from the opposite end.

Usefully, one or more of the copper parts of the flexible printed circuit board 22 is configured to form, or in any case constitutes, a shield capable of electrically shielding, at least in part, capacitive electrical leakage that is generated between the electrical winding 10 and the outer ferromagnetic casing 3 that is typically connected to ground potential.

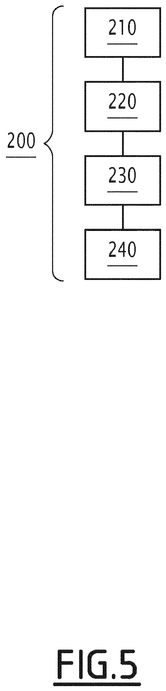

Figure 5 schematically illustrates a method 200 for manufacturing a coil 100 for an electromagnetic actuator, of the type previously described, which comprises at least the following steps:
210: winding around a support 1 an electrical winding 10 comprising a plurality of turns;
220: wrapping, at least in part, around said electrical winding 10, an electronic circuit 20 comprising a flexible printed circuit board 22 on which there are arranged one or more electronic components 24.

For example, prior to step 220, the flexible printed circuit board 22 is laid out on a flat surface for assemblying the electronic component 24; subsequently, in step 220 it can be bent and wrapped around the conducting wire forming the coils of the electrical winding 10.

In particular, according to a possible embodiment, as previously indicated, the flexible printed circuit board 22 is provided with a double-sided adhesive tape; during execution of step 220, when the flexible printed circuit board 22 is wrapped around the electrical winding 10, the double-sided adhesive tape attaches the flexible printed circuit board 22 to the electrical winding 10 itself.

In another possible embodiment, prior to step 220, a tape 11 (shown in Figure 3) can be placed on the outer surface of the electrical winding 10.

According to this embodiment, when in step 220 the flexible printed circuit board 22 is wrapped around the electrical winding 10, and in particular around the tape 11, the double-sided adhesive tape provided to the flexible printed circuit board 22, attaches the flexible printed circuit board 22 onto the tape 11.

In a possible embodiment, the method 200 also includes a step 230 which includes or consists of soldering the ends 12 of the electrical winding 10 directly onto the flexible printed circuit board 22.

According to a further embodiment, the method 200 further includes a step 240 consisting of mechanically solidarizing said electrical winding 10 and said electronic circuit 20 with each other.

In particular, according to a possible embodiment, the solidarization step 240 includes or consists of casting at least one layer of resin 15 so as to encapsulate, at least in part, and mechanically solidarizing together, said electrical winding 10 and said electronic circuit 20.

According to an alternative embodiment, the step 240 includes co-molding, by the use of at least one additional layer of plastic material, e.g., thermoplastic or thermoset, at least part of said electrical winding 10 and said electronic circuit 20, mechanically solidarizing them with each other.

It has been found in practice that the coil 100 according to the invention allows achieving the intended purpose because, compared with known solutions, it has a space-saving structure whose realization is simplified and costs reduced.

In particular, the use of the flexible circuit wrapped around the electrical winding allows for a compact solution with the electronic components 24 being installed on the flexible circuit 22 and occupying the available space between the flexible circuit itself and the outer casing 3.

In this way, the plastic enclosures outside the actuator, typical of known solutions, are eliminated and there is the possibility of extending the area available for the assembly of the electronic components to the entire outer surface of the winding 10 using a single flexible printed circuit board, as well as of integrating temperature sensors to protect the solenoid directly on the printed circuit board.

In addition, this configuration allows the ends of winding 10 to be soldered directly onto the flexible circuit board 22, eliminating the need for additional cables and/or connectors.

The use of the layer of resin 15 or plastic material 15 enhances mechanical robustness and gives high electrical insulation capacity between the electrical winding 10 and the outer casing 3.

The interposition of the flexible printed circuit board between the electrical winding 10 and the outer shell or casing 3 also allows a reduction in parasitic capacitances between these two parts resulting in reduced conducted emissions for electronic circuits using switching control (PWM), improved immunity to conducted noise that also closes through these parasitic capacitances.

With further advantage, the coil 100 according to the invention can be used in principle in any kind of electromagnetic actuator, especially of the linear type. Therefore, a further object of the present invention relates to an electromagnetic actuator characterized by comprising at least one coil 100 as above described, and more particularly defined in the appended claims.

In particular, such an actuator is an actuator for the actuation of an associated electric circuit breaker.

Of course, without prejudice to the principle of the invention, the forms of actuation and details of embodiment may be widely varied from what has been described and illustrated purely by way of preferred but not limiting examples, without thereby departing from the scope of protection of the present invention as defined in particular by the appended claims. For example, the embodiments previously described may be combined with each other, even partially, by selecting for this purpose one or more of the features described with reference to one possible embodiment and using where useful or possible each feature selected in one of the other embodiments described. The form of the described components or parts thereof may be suitably modified as long as it is compatible with the purpose and functionality for which such components were designed within the scope of the present invention.

## Claims

1. Coil (100) for an electromagnetic actuator, comprising at least:
- a support (1);
- an electrical winding (10) comprising a plurality of turns wound around the support (1);
**characterized in that** it further comprises an electronic circuit (20) which comprises a flexible printed circuit board (22) on which there are arranged one or more electronic components (24) and which is wound, at least in part, around said electrical winding (10).

2. Coil (100) according to claim 1, wherein the ends (12) of the electrical winding (10) are soldered directly onto the flexible printed circuit board (22).

3. Coil (100) according to one or more of the preceding claims, further comprising at least one layer of resin (15) which encases, at least in part, said electrical winding (10) and said electronic circuit (20).

4. Coil (100) according to one or more of claims 1 or 2, further comprising at least one layer of plastic material co-molded with at least part of said electrical winding (10) and electronic circuit (20).

5. Coil (100) according to one or more of the preceding claims, further comprising a ferromagnetic casing (3) disposed externally around said electrical winding (10) with said electronic circuit (20) interposed therebetween.

6. Coil (100) according to claim 5, wherein said flexible printed circuit board (22) comprises at least a copper portion configured to electrically shield, at least in part, capacitive electrical leakages generated between said electrical winding (10) and said external ferromagnetic casing (3).

7. An electromagnetic actuator comprising at least one coil (100) according to one or more of the preceding claims.

8. Method (200) for manufacturing a coil (100) for an electromagnetic actuator, **characterized in that** it comprises the following steps:
(210): winding around a support (1) an electrical winding (10) comprising a plurality of turns;
(220): wrapping at least in part, around said electrical winding (10), an electronic circuit (20) comprising a flexible printed circuit board (22) on which one or more electronic components (24) are arranged.

9. Method (200) according to claim 8, further comprising a step (230) of soldering the ends (12) of the electrical winding (10) directly onto the flexible printed circuit board (22).

10. Method (200) according to one or more of claims 8 and 9, further comprising a step (240) of mechanically solidarizing the electrical winding (10) with said electronic circuit (20), said mechanical solidarization step (240) comprising:
- casting at least one layer of resin (15) so as to at least partially encase, said electrical winding (10) and said electronic circuit (20), or alternatively:
- co-molding, by using at least one layer of plastic material, at least part of said electrical winding (10) and said electronic circuit (20).
